(19) Europäisches Patentamt
European Patent Office
Office européen des brevets

(11) **EP 2 119 012 B1**

(12) **EUROPEAN PATENT SPECIFICATION**

(45) Date of publication and mention
of the grant of the patent:
**08.07.2015 Bulletin 2015/28**

(21) Application number: **08706329.3**

(22) Date of filing: **29.01.2008**

(51) Int Cl.:
*H03L 7/08* (2006.01)        *H03K 5/135* (2006.01)
*H03K 5/14* (2014.01)        *H03L 7/089* (2006.01)
*H03L 7/099* (2006.01)       *H03K 5/00* (2006.01)

(86) International application number:
**PCT/CA2008/000182**

(87) International publication number:
**WO 2008/092249 (07.08.2008 Gazette 2008/32)**

(54) **PHASE SHIFTING IN DLL/PLL**

PHASENVERSCHIEBUNG BEI DLL/PLL

DÉPHASAGE DANS DES SYSTÈMES DE BOUCLE À VERROUILLAGE DE RETARD (DLL)/BOUCLE À VERROUILLAGE DE PHASE (PLL)

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **30.01.2007 US 668862**
**27.03.2007 US 691849**

(43) Date of publication of application:
**18.11.2009 Bulletin 2009/47**

(60) Divisional application:
**15164194.1**

(73) Proprietor: **Conversant Intellectual Property Management Inc.**
**Ottawa, ON K2K 0G7 (CA)**

(72) Inventors:
• **MAI, Huy, Tuong**
**Kanata, Ontario K2K 3A6 (CA)**
• **MILLAR, Bruce**
**Stittsville, Ontario K2S 1B6 (CA)**

(74) Representative: **Lang, Johannes**
**Bardehle Pagenberg Partnerschaft mbB**
**Patentanwälte, Rechtsanwälte**
**Prinzregentenplatz 7**
**81675 München (DE)**

(56) References cited:
**US-A- 4 792 705          US-A- 5 734 279**
**US-A1- 2004 085 106      US-A1- 2006 170 471**
**US-B1- 6 407 601         US-B1- 6 483 389**
**US-B2- 6 271 729         US-B2- 6 472 914**
**US-B2- 6 952 462**

## Description

## FIELD OF THE INVENTION

The present invention relates generally to charge pump circuits.

## BACKGROUND OF THE DISCLOSURE

As will be appreciated by those skilled in the art, a charge pump can be characterized as a circuit that uses capacitors to create either a higher or lower voltage. Charge pumps are used in a variety of different applications such as, for example, applications involving Delay Locked Loops (DLLs) and Phase-Locked Loops (PLLs).

With respect to PLLs, a charge pump can be used to provide a control voltage applied to a Voltage Controlled Oscillator (VCO). Typically, a PLL includes a phase detector, a loop filter coupled to the output of the charge pump, an amplifier, and a VCO interconnected in a known manner to form a feedback system. The charge pump converts logic level pulses generated by the phase detector into current pulses which are fed to the loop filter. The loop filter integrates the current pulses to produce a control voltage for the VCO.

With respect to DLLs, a charge pump can be used to provide a control voltage for a Voltage Control Delay Line (VCDL) of the DLL. As will be appreciated by those skilled in the art, in certain types of devices (for example, DRAM devices) a DLL can be used to change the phase of a clock signal. In this regard, a DLL includes a delay chain composed of number of delay gates connected in series (in a daisy chain manner).

Thus the charge pump is an important component in PLLs and DLLs, and many issued patent are directed towards them. One such patent is U.S. patent No. 7,092,689 of Boecker et al. which discloses a charge pump including a first array of mirror devices for producing, within the charge pump, a positive delta current, and a second array of mirror devices for producing, within the charge pump, a different delta current. Each mirror device in either of the arrays has current mirrored into it from a different reference current source, and the phase shift producing currents generated by the arrays do not track the charge pump current. As a result, trying to calculate the effects of the arrays under actual operating conditions based upon the conditions existing at testing/calibration time is difficult.

Accordingly, it would be advantageous to improve upon charge pump circuits that facilitate phase shifting in a DLL or PLL.

US 6,483,389 B1, against which the preamble is based on, discloses a phase and frequency detector providing charge-up signals to a charge pump in a PLL.

## SUMMARY

According to one example embodiment, there is a method for charging and discharging a capacitance In a feedback system. The feedback system includes a charge pump in electrical communication with the capacitance. The charge pump has a source portion and a sink portion. The method includes the step of generating a source current from the source portion when a charge up control signal is at an active logic level. The source current charges the capacitance. The method also includes the step of generating a sink current from the sink portion when a charge down control signal is at an active logic level. The sink current discharges the capacitance. The method also includes the step of carrying out fine-tune phase shifting by generating at least one offset current in at least a selected one of the source and sink portions. The offset current tracks the charge pump current and is generated irrespective of either of the control signals.

According to another example embodiment, there is a charge pump circuit that includes a capacitor connected in parallel to an output node. A reference current source generates a reference current. A primary current switching circuit charges the capacitor with a source current and discharges the capacitor with a sink current. The source current tracks the reference current and the sink current tracks the reference current. A supplemental source circuit sources a positive phase shift producing current which has a range of magnitudes. A magnitude of the positive phase shift producing current is determined by at least one source selection signal. The positive phase shift producing current tracks the same current tracked by the source current. A supplemental sink circuit for sources a negative phase shift producing current which has a range of magnitudes. A magnitude of the negative phase shift producing current is determined by at least one sink selection signal. The negative phase shift producing current tracks the same current tracked by the sink current.

According to another example embodiment, there is a method for providing charge up and charge down control signals having active and inactive logic levels to a charge pump in a delay-locked loop. The charge pump charging a capacitance in response to the active logic level of the charge up signal, and discharging the capacitance in response to the active logic level of the charge down signal. In response to detection of a first edge of a reference clock signal, there is a change of logic levels of the charge down signal from the inactive logic level of the charge down signal to the active logic level of the charge down signal. In response to detection of an edge of a feedback clock signal falling within less than 180 degrees from the first edge, there is a change of logic levels of the charge up signal from the inactive logic level of the charge up signal to the active logic level of the charge up signal, and there is a change of logic levels of the charge down signal from the active logic level of the charge down signal to the inactive logic level of the charge down signal. In response to detection that an edge of an additional reference signal at a point in time about midway between the first edge and a subsequent edge of the reference clock signal has past, changing the active logic level of the charge up signal to the inactive logic level, while maintaining the charge down signal at the inactive logic level.

Expediently, charging and discharging can, in some examples, be disabled during a period of time between the midway point in time and the subsequent edge of the reference clock signal.

Conveniently, the additional reference signal can, in some example, be 180 degrees phase shifted relative to the reference clock signal.

According to another example embodiment, there is a delay-locked loop that includes a voltage control delay line for receiving a reference clock signal and for delaying the reference clock signal to provide a feedback clock signal. A phase detector for receiving the reference clock signal and the feedback clock signal. The phase detector generating charge up and charge down control signals dependent upon a phase difference between the reference clock signal and the feedback clock signal. A loop filter includes a capacitor for providing a variable bias voltage for selecting a delay to be added to the reference clock signal by the voltage control delay line. A charge pump includes at least two switching transistors. One of the switching transistors permits current to be added into the capacitor when switched on in response to the charge up signal. Another of the switching transistors permits current to be removed from the capacitor when switched on in response to the charge down signal. The switching transistor of source current is controlled by the charge up signal and the switching transistor of sink current is controlled by the charge down signal. The phase detector receives the reference clock signal, an additional reference signal, and the feedback clock signal. The phase detector generates a charge up control signal having a first duration of time in response to a first edge of the reference clock signal. A charge down control signal has a second duration of time in response to an edge of the feedback clock signal occurring within less than 180 degrees from the first edge. The first duration of time is substantially similar to a first time between the first edge of the reference clock signal and the edge of the feedback clock signal. The second duration of time is substantially similar to a second time between the edge of the feedback clock signal and a midway signal edge occurring between the first edge and a subsequent edge of the reference clock signal.

Conveniently, during one period of the reference clock signal the charge pump is, in some examples, disabled during about half of the period.

Expediently, the phase detector includes, in some examples, at least four D Flip-Flops, and each of the clock signals is received by at least one of the D Flip-Flops at a clock input.

According to yet another example embodiment, there is a delay-locked loop that includes a voltage control delay line for receiving a reference clock signal. A phase detector also receives the reference clock signal and generates charge up and charge down control signals dependent upon a phase difference between the reference clock signal and a feedback clock signal. A loop filter includes a capacitor. The loop filter integrates the charge up and charge down control signals to provide a variable bias voltage for selecting a delay to be added to the reference clock signal by the voltage control delay line. A source portion of a charge pump includes at least one switching transistor, a first sourcing transistor and at least another sourcing transistor. The sourcing transistors are in electrical communication with the capacitor. At least a current carrying terminal of the first sourcing transistor is electrically connected to a current carrying terminal of the source portion switching transistor. The source portion switching transistor is controlled by the charge up control signal and, if switched on, permits current to be sourced via the first sourcing transistor into the capacitor. The source portion further includes means for disabling the sourcing of current via the first sourcing transistor. A sink portion of the charge pump includes at least one switching transistor, a first sinking transistor and at least another sinking transistor. The sinking transistors are in electrical communication with the capacitor. At least a current carrying terminal of the first sinking transistor is electrically connected to a current carrying terminal of the sink portion switching transistor. The sink portion switching transistor is controlled by the charge down control signal and, if switched on, permits current to be sunk via the first sinking transistor from the capacitor. The sink portion further includes means for disabling the sinking of current via the first sinking transistor.

Conveniently, the current sourcing disabling means and the current sinking disabling means can, in some examples, each include a select transistor, the current sourcing or sinking via the first sourcing or sinking transistor being disabled if the select transistor is turned off.

Expediently, the current sourcing disabling means and the current sinking disabling means can, in some alternative examples, each include transmission gate means between a bias voltage terminal of a mirror master transistor and a bias voltage terminal of the first sourcing or sinking transistor, the current sourcing or sinking via the first sourcing or sinking transistor being disabled if the transmission gate means breaks a conduction path between the two bias voltage terminals.

Conveniently, the source portion switching transistor and the sourcing transistors can, in some examples, be PMOS transistors, and the sink portion switching transistor and the sinking transistors can, in some examples, be NMOS transistors.

Expediently, one current carrying terminal of each of the sourcing (or sinking) transistors can, in some examples, collectively all be electrically connected to the current carrying terminal (e.g. drain) of the source (or sink) portion switching transistor.

Conveniently, the charge pump can, in some alternative examples, further include another source portion switching transistor and another sink portion switching transistor, a current carrying terminal of the another sourcing transistor being electrically connected to a current carrying terminal of the another source portion switching transistor, and a current carrying terminal of the another sinking transistor being electrically connected to a current carrying terminal of the another sink portion switching transistor.

## BRIEF DESCRIPTION OF THE DRAWINGS

Reference will now be made, by way of example, to the accompanying drawings which illustrate example embodiments:

Figure 1 is a block diagram of a prior art DLL;
Figure 2 is a block diagram of a prior art PLL;
Figure 3 is a circuit schematic of a phase detector and a charge pump that receives control signals from the phase detector;
Figure 4 is a timing diagram illustrating the operation of the phase detector of Figure 3;
Figure 5 is a circuit schematic of a phase detector in accordance with an example embodiment;
Figure 6 is a timing diagram illustrating the operation of the phase detector of Figure 5;
Figure 7 is a circuit schematic of a charge pump in accordance with an example embodiment; and
Figure 8 is a circuit schematic of a charge pump in accordance with another example embodiment;
Figure 9 is a circuit schematic of a charge pump in accordance with yet another example embodiment; and
Figure 10 is a circuit schematic of a charge pump in accordance with yet another example embodiment.

## DETAILED DESCRIPTION OF EXAMPLE EMBODIMENTS

In the following detailed description of example embodiments, a number of illustrated circuits and circuit components are of a type which performs known operations on electronic signals. Those skilled in the art will have knowledge of alternative circuits or circuit components which are recognized as equivalent because they provide the same operations on the signals. Similar or the same reference numerals and labeling may have been used in different figures to denote similar components or signals.

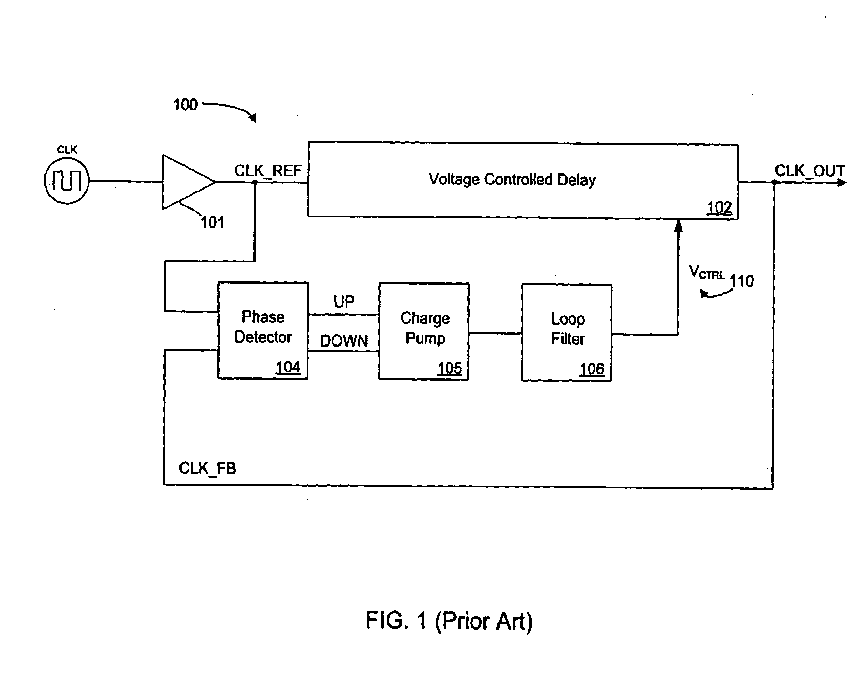

Referring now to the drawings, Figure 1 is a block diagram of a prior art Delay-Locked Loop (DLL) **100**. In the DLL **100**, an externally supplied clock (CLK) is buffered by clock buffer **101** to provide a reference clock (CLK_REF). As understood by those skilled in the art, the CLK signal could be, for example, a data strobe signal (DQS or DQSb signal) transmitted from a memory controller to a memory device. However, it is of course possible that the CLK signal will, in alternative examples, be some other type of clock signal. Continuing on with the discussion of the DLL block diagram of Figure 1, it will be seen that CLK_REF is coupled to a Voltage Controlled Delay Line (VCDL) **102** and a phase detector **104**. The VCDL **102** produces an output clock (CLK_OUT), which is a delayed version of CLK_REF and is routed to various circuits within the device containing the DLL **100**. As shown, CLK_OUT is also routed to the phase detector **104**, and thus the phase detector **104** receives CLK_OUT as a feedback clock signal, referred to as CLK_FB.

With respect to phase shifting by the DLL, those skilled in the art will appreciate that in some memory systems where the timing signal-being phase shifted is DQS or DQSb (the complement of DQS), the timing signal will be shifted by 90 degrees so that the edges of the timing signal are centered with respect to its associated data. Also, as clock frequencies in memory systems become increasingly higher, the ability to make fine-tuned phase shifting adjustments will continue to become increasingly useful.

Still with reference to the illustrated DLL **100**, the phase detector **104** generates phase control signals (UP/DOWN) dependent on the phase difference between CLK_REF and CLK_FB. The phase control signals (UP/DOWN) of the phase detector **104** are provided to a charge pump **105**, the output thereof which is conditioned by a loop filter **106** to provide a variable bias voltage $V_{CTRL}$ **110**. Those skilled in the art will understand that loop filter **106** can include any number of passive components arranged in a desired configuration. The bias voltage $V_{CTRL}$ selects the delay to be added to CLK_REF by the VCDL **102** to provide for the proper phase relation between CLK_FB and CLK_REF. VCDL **102** can be implemented with a variety of known circuits.

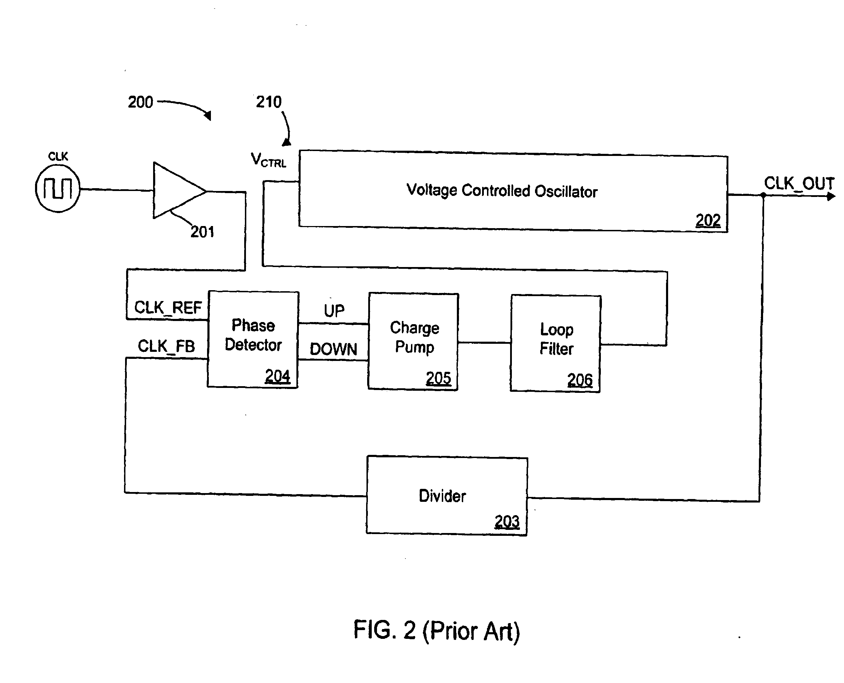

Another type of feedback system known to those skilled in the art of memory design is a Phase-Locked Loop (PLL). Figure 2 is a block diagram of a prior art PLL **200**. An externally supplied clock (CLK) is buffered by clock buffer **201** to provide a reference clock (CLK_REF) that is coupled to a phase detector **204**. The phase detector **204** generates phase control signals (UP/DOWN) dependent on the phase difference between CLK_REF and CLK_FB.

The phase control signals (UP/DOWN) of the phase detector **204** are provided to a charge pump **205**, the output thereof which is conditioned by a loop filter **206** to provide a variable bias voltage $V_{CTRL}$ **210**. The bias voltage $V_{CTRL}$ controls a Voltage Controlled Oscillator (VCO) **202** which outputs a clock signal CLK_OUT. The frequency of the output clock signal CLK_OUT is proportional to the bias voltage $V_{CTRL}$ **210**. Also, the CLK_OUT signal is optionally coupled to a divider **203** to produce the CLK_FB signal.

Having now described the general architecture of PLLs and DLLs, it will be understood that the operation of a particular DLL will not always be independent of other PLLs present in the larger memory design. For example, two 90 degree phase shifted DQS and DQSb signals available within a master PLL can be provided to a slave DLL. It will be understood that, in such circumstances, the slave DLL output is dependent upon the phase and frequency information that the master PLL provides. This dependency is not necessarily disadvantageous, and it has been found, generally speaking, that slave DLLs relying upon master PLLs, as described above, provide output clocks that are, for a large majority of presently existing applications, properly phase shifted relative to the reference clock.

From the preceding cursory descriptions of PLLs and DLLs, it will be seen that if a PLL is examined and its components are compared to a DLL, one will find that at least some of the components of the PLL are similar to components in the DLL. For one, both a PLL and a DLL include a phase detector. Additionally, both a PLL and a DLL include a charge pump.

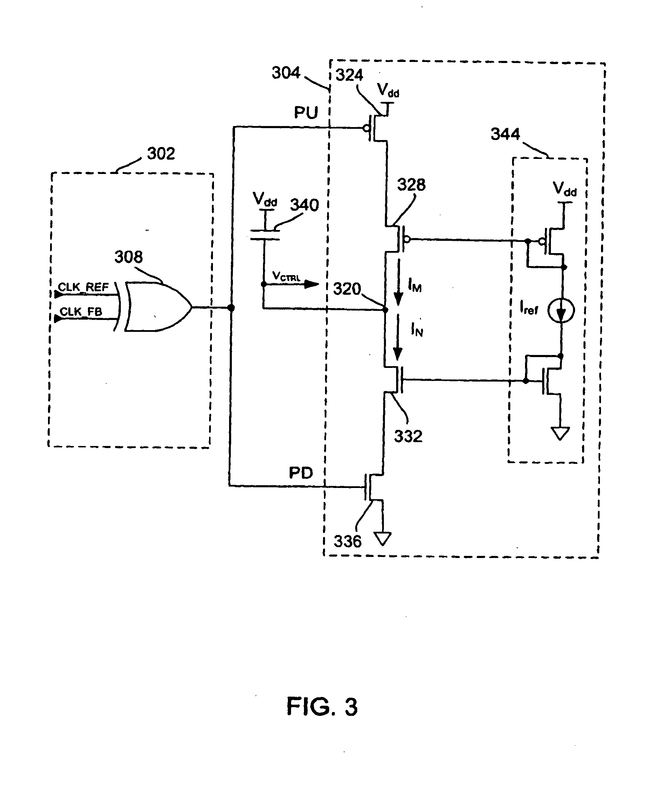

Turning now to Figure 3, there is a circuit schematic representation of an XOR-type phase detector **302** and a charge pump **304** (some circuit components not relevant to an understanding of example embodiments may have been omitted from Figure 3). Those skilled in the art will appreciate that while XOR-type phase detectors can be employed in both DLLs and PLLs, their use is more common in DLLs; however their use in PLLs is also possible if the relevant design issues (for example, harmonic locking) are addressed.

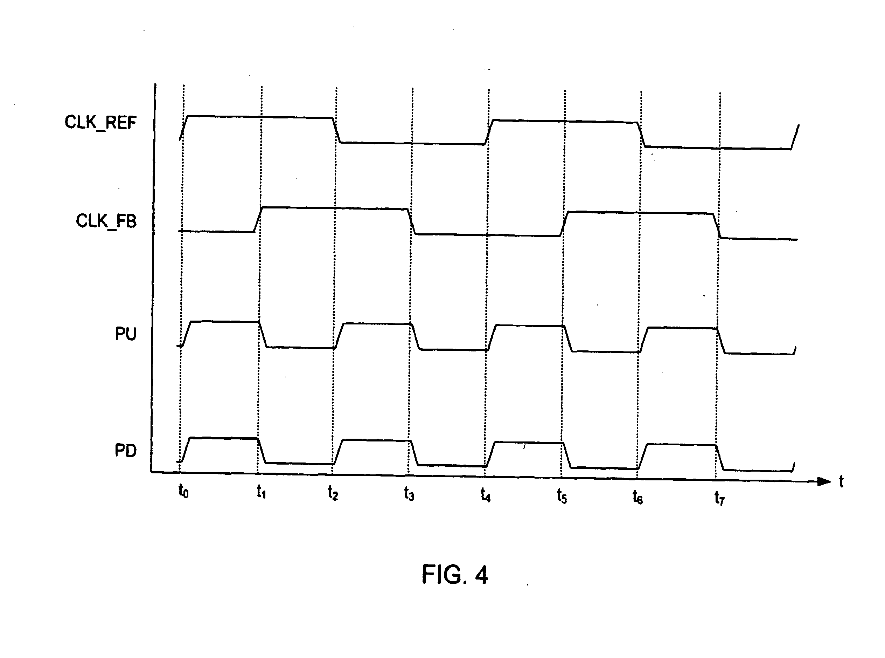

The phase detector **302** is level sensitive and includes an XOR logic gate 308 to which the signals CLK_REF and CLK_FB are applied at the inputs of the XOR logic gate **308**. The output of the XOR logic gate **308** is electrically connected to both the gate of the switching transistor **324** and the gate of the switching transistor **336**. In operation, when the two compared signals CLK_REF and CLK_FB are completely in phase, the pair of in phase inputs to the XOR logic gate **308** will result in XOR gate outputting a constant level of logic '0'. When the two compared signals CLK_REF and CLK_FB are 180 degrees apart (one is logic '0' when the other is logic '1', and vice versa) the XOR logic gate **308** puts out a steady logic '1' signal. Between the two extremes, the XOR logic gate **308** outputs logic '1' for half of the cycle. Thus, Figure 4 is a timing diagram illustrating CLK_REF, CLK_FB, Pulse Up (PU) control signal and Pulse Down (PD) control signal when the XOR logic gate 308 outputs logic '1' for half of the cycle. (It has been assumed for the above description that both compared signals CLK_REF and CLK_FB have 50 percent duty cycles.)

With respect to the illustrated charge pump **304**, it includes a source portion and a sink portion between which is a $V_{CTRL}$ node **320**. The sourcing portion includes a switching transistor **324** and a sourcing transistor **328**, which are PMOS transistors in the illustrated example. The sinking portion includes a switching transistor **336** and a sinking transistor **332**, which are NMOS transistors in the illustrated example. The illustrated charge pump **304** also includes a current mirror **344** for mirroring current in the transistors **328** and **332**. Generally, current mirror **344** is a reference current source circuit. The current mirror **344** also establishes the bias voltages being applied to the gates of the transistors **328** and **332**. A capacitor **340** has one terminal electrically connected to $V_{dd}$ and another terminal electrically connected to the $V_{CTRL}$ node **320**. As will be appreciated by those skilled in the art, $V_{CTRL}$ can be changed by net charging or net discharging of the capacitor **340**, and by bringing about a change in $V_{CTRL}$, a phase shift can be effected. Capacitor **340** can be a passive component of the loop filter, or alternately, capacitor **340** can be a component of charge pump **304**.

Charging is achieved by adding current to the capacitor **340**, while discharging is achieved by removing current from the capacitor **340**. It will be seen that if currents $I_M$ and $I_N$ have equal magnitudes over a period of time, then the capacitor **340** will continually charge and discharge by equal amounts and equal durations resulting in no net change to voltage $V_c$ at the $V_{CTRL}$ node **320**.

The conditions for equal $I_M$ and $I_N$ magnitudes in the illustrated example charge pump is as follows. $I_M$ and $I_N$ will have equal magnitudes if, for example (i) the width-to-length (W/L) ratio of the transistor **328** and the PMOS FET of the current mirror **344** are equal; and (ii) the W/L ratio of the transistor **332** and the NMOS FET of the current mirror **344** are equal. (In at least one example, regulation of current is further facilitated by use of an operational amplifier as described and illustrated in commonly assigned US patent application Publication No. 2005/0162200 of Haerle.)

With respect to when $I_M$ and $I_N$ will have equal durations in the illustrated example charge, under the assumption of clocks of 50 percent duty cycle, $I_M$ and $I_N$ will repeatedly be current pulses of the same duration if the CLK_FB signal is phase shifted by 90 degrees with respect to the CLK_REF signal.

Figure 4 is a sequence, or timing, diagram showing the operation of phase detector 302 of Figure 3. Figure 4 illustrates traces for input signals CLK_REF, CLK_FB and output signals PU and PD. It is assumed that the circuit is operating at a steady state, meaning that CLK_FB has reached the 90 degree phase shift relative to CLK_REF. As shown in Figure 4, in one full CLK_REF clock cycle (ie. between to and $t_4$), signals PU and PD will cycle between the high and low logic states. Therefore, transistors **324** and **336** are constantly, and alternately, turned on and off.

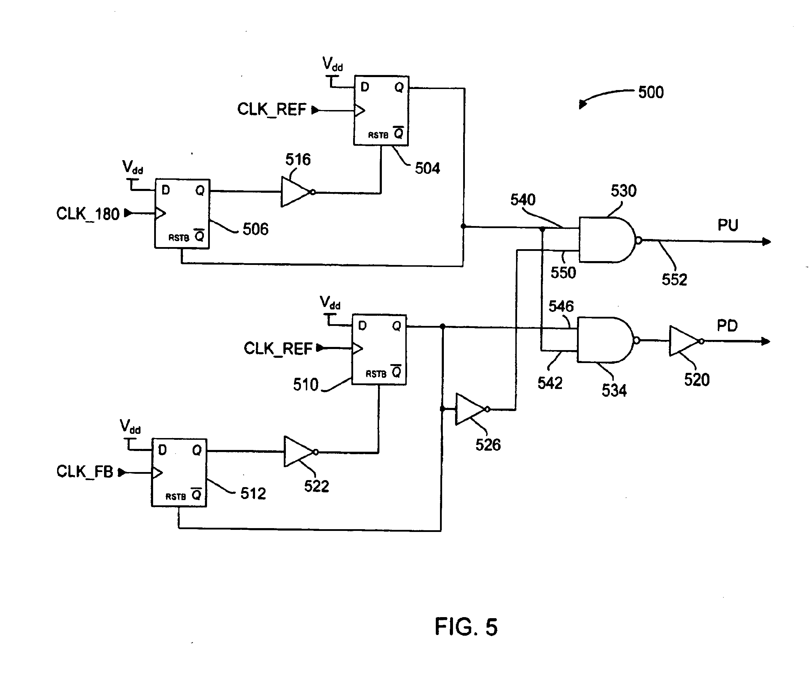

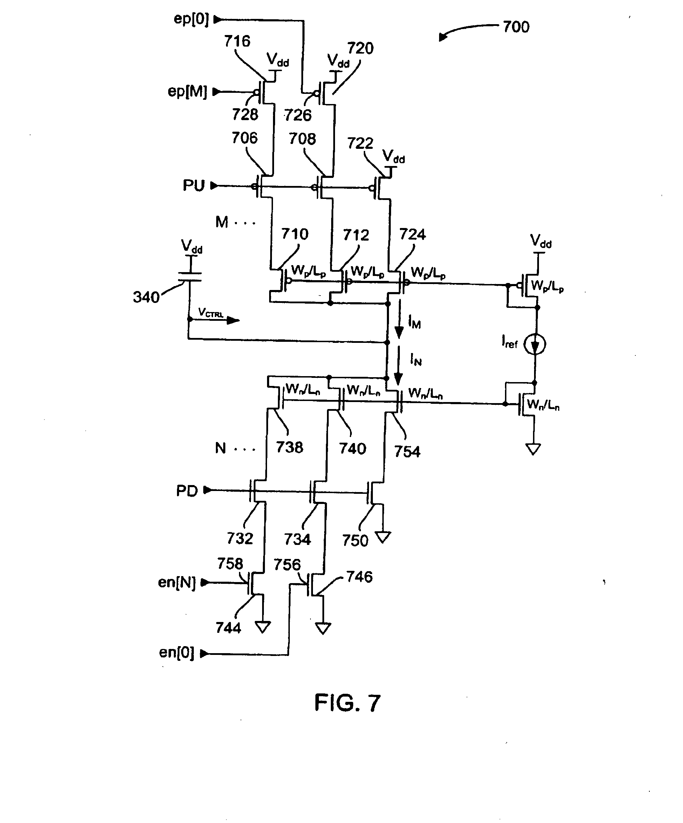

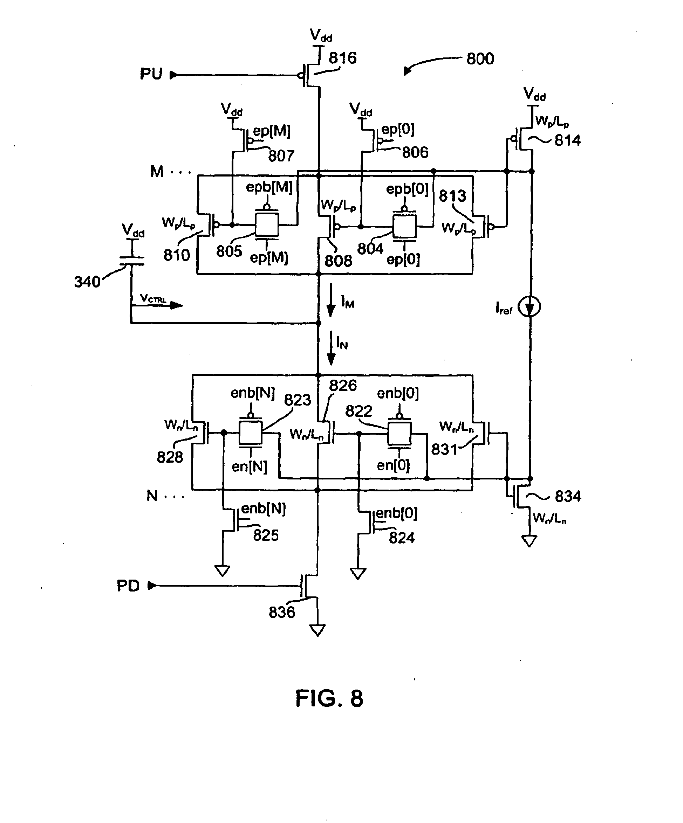

Reference will now be made to Figure 5. Figure 5 is a circuit schematic of a phase detector 500 in accordance with an example embodiment. As will be appreciated by those skilled in the art, not all components that will be present in an actual implementation have been illustrated, these absent components having been omitted in order to improve clarity and with an appreciation that their inclusion would not consequently impact an understanding of the illustrated example embodiment. The phase detector **500** can be employed within a DLL like the DLL shown in Figure 1 (from a system perspective). Employment of the phase detector 500 within a PLL like the PLL shown in Figure 2 (from a system perspective) may be less likely; however if the relevant design issues (for example, harmonic locking) are addressed, use of the phase detector 500 within PLLs is also possible. Also, the phase detector 500 may, in some examples, be used in combination with the charge pump circuits of Figures 7 and 8 (descriptions of which are provided in later paragraphs of this disclosure).

The illustrated phase detector 500 includes: four D Flip-Flops 504, 506, 510 and 512, four inverters 516, 520, 522 and 526, and two NAND logic gates 530 and 534. The illustrated phase detector 500 receives four input signals: CLK_REF, CLK_FB, CLK_180 and $V_{dd}$. CLK_REF is electrically connected to the clock inputs of the D Flip-Flops 504 and 510. (Each of the D Flip-Flops illustrated in Figure 5 is rising-edge triggered.) CLK_FB is electrically connected to the clock input of the D Flip-Flop 512. CLK_180, which is a 180 degree phase shifted version of CLK_REF, is electrically connected to the clock input of the D Flip-Flop 506. Finally, $V_{dd}$ is electrically connected to the inputs of the D Flip-Flops 504, 506, 510 and 512.

Still with reference to the D Flip-Flops, the output of the D Flip-Flop 504 is electrically-connected to a first input of the NAND logic gate 530, a first input of the NAND logic gate 534, and the reset (RSTB) terminal of the D Flip-Flop 506. Also, the output of the D Flip-Flop 506 is electrically connected to the input of the inverter 516, the output of the inverter 516 being electrically connected to the RSTB input of the D Flip-Flop 504. The output of the D Flip-Flop 510 is electrically connected to a second input of the NAND logic gate 534, and also the RSTB input of D Flip-Flop 512 and the input of inverter 526, the output of the inverter 526 being electrically connected to a second input of the NAND logic gate 530. Additionally, the output of the D Flip-Flop 512 is electrically connected to the input of inverter 522, the output of the inverter 522 being electrically connected to the RSTB input of the D Flip-Flop 510.

A Pulse UP (PU) control signal provided to a charge pump is generated at the output of the NAND logic gate 530. (It will be understood that the term charge up control signal used in this application also refers to a control signal for controlling charging within a charge pump.) A Pulse Down (PD) control signal, which is also provided to the charge pump, is generated at the output of the inverter 520, the output of the NAND logic gate 534 being electrically connected to the input of the inverter 520. (It will be understood that the term charge down control signal used in this application also refers to a control signal for controlling discharging within a charge pump.)

In operation, the PU and PD signals produced by the illustrated phase detector 500 will cause, within the charge pump to which these signals are electrically connected, $V_{CTRL}$ node capacitor charging/discharging activity during only half of the clock period. This behavior of the phase detector 500 will be apparent when the operation of the D Flip-Flops 504, 506, 510 and 512 is understood.

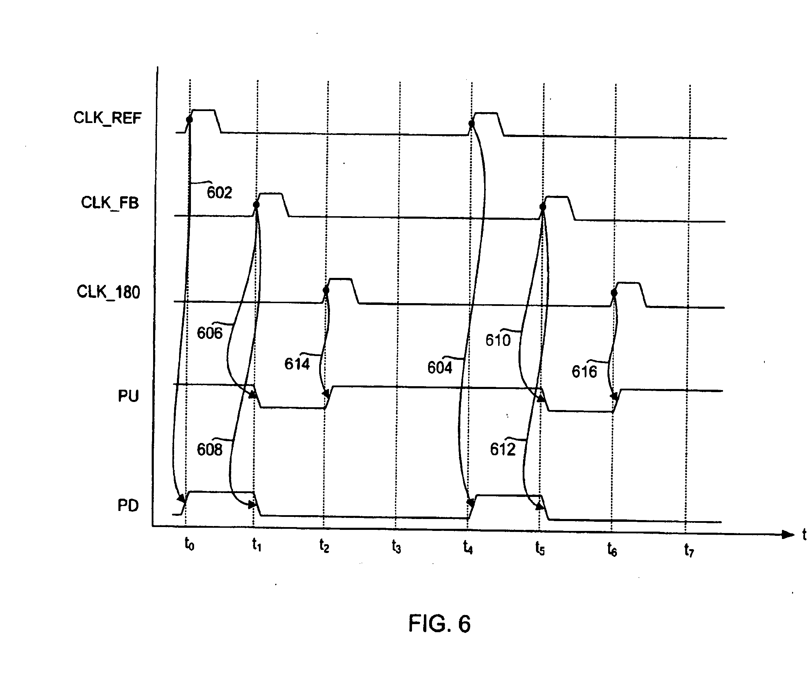

In the behavioral description of the phase detector 500 that follows, reference will be made to both Figures 5 and 6. Figure 6 is a timing/sequence diagram illustrating the operation of the phase detector 500 with CLK_FB phase shifted 90 degrees relative to CLK_REF (as previously explained, in some examples this will be the desired phase shift for the clock signal so that the clock signal is properly aligned in the center of its associated data). Also, it will be understood that the clock signals illustrated in Figure 6 have duty cycles that are significantly less than 50 percent, but have the same period as the clock signals shown in Figure 4. Those skilled in the art will understand that clocks having a 50 percent duty cycle can be used.

As explained in more detail below, in response to detection of a rising edge of CLK_REF (reference clock signal) the PD control signal will change logic levels (logic '0' to logic '1') and also the logic level of the PU control signal will be maintained (the logic level will stay at logic '1') thereby enabling charge pump discharging, while keeping charge pump charging disabled. Referring to the D Flip-Flops 504 and 510, these Flip-Flops output the logic level on their input, which is logic '1' ($V_{dd}$) on the rising edge of CLK_REF. The logic '1' on the output of the D Flip-Flop 504 is received at an input 540 of the NAND logic gate 530 and at an input 542 of the NAND logic gate 534. The logic '1' at the output of the D Flip-Flop 504 is also received by the RSTB input of the D Flip-Flop 506, which is ignored because the RSTB input is active "low". The logic '1' at the output of the D Flip-Flop 510 is received by input 546 of the NAND logic gate 534 and the input of the inverter 526, which inverts the logic '1' to a logic '0' that is received at input 550 of the NAND logic gate 530. The logic '1' at the output of the D Flip-Flop 510 is also received by the RSTB input of the D Flip-Flop 512, but again, as previously explained, the D Flip-Flop 512 ignores this. If a logic '1' received at the input 540 and a logic '0' is received at the input 550, output 552 of the NAND logic gate 530 will be logic '1'. Therefore, the PU signal is logic '1' with the result being that charging in the charge pump remains disabled. With a logic '1' signal on the input 546 of the NAND logic gate 534 and a logic '1' signal on the input 542 of the NAND logic gate 534, the output of the NAND logic gate 534 is logic '0'. The inverter 520 inverts the signal so that the PD signal will be logic '1' enabling the charge pump, with respect to which the phase detector 500 communicates its control signals, to carry out discharging. Thus, in response to detection of a rising edge of CLK_REF, the PD control signal will change logic levels, as shown by transition arrows 602 and 604 in Figure 6.

The next rising edge occurs in the CLK_FB signal (feedback clock signal). (Those skilled in the art will appreciate that harmonic locking problems can occur in PLLs if the edge of the CLK_FB signal becomes more than 180 degrees out of phase from the corresponding edge in the CLK_REF signal.) As explained in more detail below, in response to detection of the rising edge of CLK_FB, the PU control signal will change logic levels (logic '1' to logic '0') and also the PD control signal will change logic levels (logic '1' to logic '0') thereby enabling charge pump charging and disabling charge pump discharging. Referring to the D Flip-Flop 512, its clock input receives the CLK_FB signal. In response, the D Flip-Flop 512 outputs a logic '1' which is inverted by the inverter 522. A logic '0' at the RSTB input of the D Flip-Flop 510 forces the output of the D Flip-Flop 510 to logic '0', and this change in logic levels causes logic '0' to be received at the input 546 and logic '1' to be received at the input 550. The outputs of the NAND logic gates 530 and 534 now change their logic levels so that the PU signal changes from logic '1' to logic '0' enabling charging within the charge pump, and also the PD signal changes from logic '1' to logic '0' disabling discharging within the charge pump. Thus, in response to detection of a rising edge of CLK_FB, both the PU and PD control signals will change logic levels, as shown by transition arrows 606, 608, 610 and 612 in Figure 6. The transition of the PD signal from the active logic level to the inactive logic level marks the end of a duration of time substantially similar to a time between the edge of CLK_REF at to and the edge of CLK_FB at $t_1$.

The next rising edge occurs in the CLK_180 signal (an additional reference clock signal, phase shifted 180 degrees from CLK_REF, so that its rising edge is about midway between sequential rising edges of CLK_REF, providing indication of this midway point in time). As explained in more detail below, in response to detection of the rising edge of CLK_180 signal, the PU control signal will change logic levels (logic '0' to logic '1') and also the logic level of the PD control signal will be maintained (the logic level will stay at logic '0') thereby disabling charge pump charging and keeping charge pump discharging disabled. Referring to the D Flip-Flop 506, its clock input receives the CLK_180 signal. In response, the D Flip-Flop 506 outputs a logic '1' which is inverted by the inverter 516. A logic '0' at the RSTB input of the D Flip-Flop 504 forces the output of the D Flip-Flop 504 to logic '0', and this change in logic levels causes a logic '0' to be received the input 540 of the NAND logic gate 530, so the output of the NAND logic gate 530 changes from logic '0' to logic '1' while the outputs of the NAND gate 534 and the inverter 520 remain unchanged. Therefore, the PU signal changes from logic '0' to logic '1' disabling charging within the charge pump, and also the logic level of the PD signal will be maintained (the logic level will stay at logic '0') keeping charge pump discharging disabled. Thus, in response to detection of a rising edge of CLK_180, the PU control signal will change logic levels, as shown by transition arrows 614 and 616 in Figure 6. The transition of the PU signal from the active logic level to the inactive logic level marks the end of a duration of time substantially similar to a time between the edge of CLK_FB at $t_1$ and the edge of CLK_180 at $t_2$.

In a steady state, the change in the PU and PD signals triggered by the CLK_FB rising edge will occur about one quarter of a clock period subsequent to the previous change in the PD signal triggered by the rising edge of the CLK_REF signal. During the roughly one quarter clock period between the CLK_REF and the CLK_FB rising edge, discharging occurs and charging does not occur. Also in the steady state, the change in the PU signal triggered by the CLK_180 rising edge will occur about one quarter of a clock period subsequent to the previous change in the PU and PD signals triggered by the rising edge of the CLK_FB signal. During the roughly one quarter clock period between the CLK_FB and the CLK_180 rising edge, charging occurs and discharging does not occur. During the remainder of the clock period neither charging nor discharging occurs. For example, during a half clock period between times $t_2$ and $t_4$ (see timing diagram of Figure 6) neither charging nor discharging occurs (i.e., the PU and PD signals from the phase detector 500 would result in the switching transistors of the DLL's charge pump both being simultaneously switched off for half of the clock period, and hence the loop filter capacitor would be neither charged nor discharged during that period). During a corresponding period of time $t_2$ to $t_4$ for the phase detector 308 of Figure 3, charging and discharging is occurring (see the logic levels of the PU and PD signals in the timing diagram of Figure 4). The phase detector 500 may thus have the advantage of permitting implementation of a DLL with reduced power consumption as compared to the phase detector 308.

The phase detector 500 eliminates the need for the reference clock signals that were previously discussed in previous paragraphs of the disclosure, or in other words, the phase detector 500 eliminates the need to have available a master DLL or PLL that would ordinarily provide the two reference clock signals used for phase shifting (however, as explained previously and as will be discussed in more detail below, the CLK_180 signal will, in some examples, be provided to the phase detector in order for the phase detector to operate as intended).

It will be understood that an additional characteristic of the illustrated phase detector 500 is that it is edge triggered rather than level sensitive. Typically, an edge triggered phase detector will not be subject to the same duty cycle requirements that a level sensitive phase detector is subject to.

Those skilled in the art will also appreciate that phase control signals similar to those generated by the illustrated phase detector 500 can be generated by alternative phase detectors comprised of different logic gates and circuitry than the phase detector 500. For example, where CLK_REF is a 50 percent duty cycle clock, by replacing the D Flip-Flop 506 with one that is falling-edge triggered rather than rising-edge triggered, CLK_REF can be applied to the substituted D Flip-Flop, eliminating the need for CLK_180. With the D Flip-Flops **504** and **510** being triggered on a rising edge of the CLK_REF signal, the flip-flop put in substitution for the D Flip-Flop **506** is triggered on the falling edge (edge next in succession to the rising edge). While the above described implementation can be realized in some systems having phase detectors, it should be noted that in at least some instances it may be difficult to produce and make available a 50 percent duty cycle clock.

In some example embodiments, generated phase control signals may not exhibit the same logic level transitions that are characteristic of the illustrated phase detector **500**. As a simple example, if one were to add inverters along the paths between the phase detector and the gates of the switching transistors **324** and **336** (Figure 3) one of skill in the art could readily alter the design of the phase detector to respond to the previously described clock edges in a similar manner, but with generated phase control signals having bit (logic level) sequences opposite to those of the phase detector **500**.

Other alternative example phase detectors are also contemplated. For instance, it will be understood that it would be straightforward for one of skill in the art to modify the illustrated phase detector **500** to realize a phase detector that would respond to falling clock edges rather that rising clock edges. Such a phase detector could achieve at least substantially the same effects and benefits associated with the illustrated phase detector **500**.

Reference will now be made to Figure 7. Figure 7 is a circuit schematic of a charge pump **700**, in accordance with an example embodiment. As is known in the art, charge pump circuits uses capacitors to create either a higher or lower voltage. With respect to PLLs, a charge pump can be used to provide a control voltage applied to the VCO of the PLL. With respect to DLLs, a charge pump can be used to provide a control voltage for the VCDL of the DLL.

Referring now to the source portion of the illustrated charge pump **700,** in this portion there are secondary switching transistors **706** and **708,** secondary sourcing transistors **710** and **712**, and select transistors **716** and **720**. When current flows through primary switching transistor **722** and primary sourcing transistor **724,** current will only flow through the secondary switching transistor **708** and the secondary sourcing transistor **712** if a logic '0' signal is applied to gate **726** of the select transistor **720,** and current will only flow through the secondary switching transistor 706 and the secondary sourcing transistor **710** if a similar logic '0' signal is applied to gate **728** of the select transistor **716**. Thus, the sourcing of current via one or more of the secondary sourcing transistor **710** and **712** can be disabled if one or more of the select transistors **716** and **720** is made non-conducting. In the presently shown embodiment, gate **726** is controlled by enabling signal ep[0] and gate **756** is controlled by enabling signal en[0], while gate **728** and **758** are controlled by enabling signals ep[M] and en[N] respectively. M and N are integer values greater than 0, as there can be any number of select transistors and secondary switching transistors included in the circuit of Figure 7. In various alternate embodiments, N can be equal to M, or N can be different from M. $I_M$, which is the sum of the currents sourced through the sourcing transistors **710, 712** and **724,** tracks $I_{ref}$.

In the sink portion of the illustrated charge pump **700,** there are secondary switching transistors **732** and **734,** secondary sinking transistors **738** and **740,** and select transistors **744** and **746**. When current flows through primary switching transistor **750** and primary sinking transistor **754,** current will only also flow through the secondary switching transistor **734** and the secondary sinking transistor **740** if a logic '1' signal is applied at gate **756** of the select transistor **746,** and current will only flow through the secondary switching transistor **732** and the secondary sinking transistor **738** if a similar logic '1' signal is applied at gate **758** of the select transistor **744.** Thus, the sinking of current via one or more of the secondary sinking transistor **738** and **740** can be disabled if one or more of the select transistors **744** and **746** is made non-conducting. IN, which is the sum of the currents sunk through the sinking transistors **738, 740** and **754,** tracks $I_{ref}$.

As will be appreciated by those skilled in the art, source portion current $I_M$ will be greatest when all three of the sourcing transistors **710, 712** and **724** are sourcing current, and $I_M$ will be smaller when one or more of the select transistors **716** and **720** are turned off so that one or more of the secondary sourcing transistors **710** and **712** do not source additional current. Similarly, sink portion current $I_N$ will be greatest when all of the sinking transistors **738, 740** and **754** are sinking current. However, $I_N$ will be less if one or more of the select transistors **744** and **746** are turned off so that one or more of the secondary sinking transistors **732** and **734** will not sink additional current. In this manner, the illustrated charge pump **700** permits scaling of charge pump currents to be carried out.

If one takes into account that, in the illustrated charge pump 700, the phase shift corresponding to steady state will approximately follow equation (1) below:

$$\text{(1) Phase Shift} = 180^\circ\ I_N/(I_M + I_N)$$

It will be seen that scaling of charge pump currents as previously described provides for the ability to make fine-tuned adjustments in phase shifting. Also, if $I_N$ and $I_M$ are expressed as $(N+1) \cdot I_{ref}$ and $(M+1) \cdot I_{ref}$ respectively, where N and M represent the current mirror ratios, then the relationship expressed in equation (2) below also holds:

## (2) Phase Shift = 180* (N+1)/(M+N+2).

As will be appreciated by those skilled in the art, a system that includes the charge pump **700** can also include a main controller having registers that provide the enable signals for controlling which of the select transistors **716**, **720**, **744** and **746** are made conducting or non-conducting. In particular, each of the enable signals from such main controller registers would be applied to one of the gates **726**, **728**, **756** and **758**. Alternate example embodiments of Figure 7 can include any number of select transistors and corresponding secondary switching transistors. These select transistors and corresponding secondary switching transistors can be sized identically to the explicitly shown select transistors and secondary transistors to provide substantially linear scaling of the currents $I_M$ and $I_N$. Alternately, these transistors can be sized differently to provide non-linear scaling of the currents $I_M$ and $I_N$. Furthermore, any combination and number of enable signals can be driven to the activate logic level to turn on their corresponding select transistors.

Figure 8 is a circuit schematic of a charge pump **800**, in accordance with another example embodiment. As will be evident from the explanation that follows, if will be seen that the charge pump **800** scales charge pump currents in a similar matter to the charge pump **700** of Figure 7.

In the source portion of the illustrated charge pump **800**, there are M sourcing transistors (two of which are shown and labeled **808** and **810**), M transmission gates (two of which are shown and labeled **804** and **805**), M pull-up transistors (two of which are shown and labeled **806** and **807**), a mirror master transistor **814**, and a switching transistor **816**. It will be understood that the mirror master transistor **814** can mirror current in any one or more of the sourcing transistors **808** and **810**, but only if the interposed transmission gate **804** and/or **805** enables a path for the master transistor **814** to mirror current to sourcing transistor(s). Thus, the sourcing of current via one or more of the M sourcing transistors can be disabled if path(s) through the transmission gate(s) are disabled. By contrast, the sourcing of current via sourcing transistor **813** is not impacted by any of the transmission gates **804**. $I_M$, which is the sum of the currents sourced through the sourcing transistors **808**, **810**, **812** and **813**, tracks $I_{ref}$.

In the sink portion of the charge pump **800**, there are N sinking transistors (two of which are shown and labeled **826** and **828**), N transmission gates (two of which are shown and labeled **822** and **823**), N pull-down transistors (two of which are shown and labeled **824** and **825**), a mirror master transistor **834**, and a switching transistor **836**. Again, the mirror master transistor **834** can mirror current into one or more of the sinking transistors **826** and **828**, but only if the interposed transmission gates **822** and/or **823** enable a path for the master transistor **834** to mirror currents to sinking transistor(s). If one or more of the N transmission gates cause the path(s) between the sinking transistor(s) and the master transistor **834** to be closed, then current will not be mirrored into that/those sinking transistor(s). Thus, the sinking of current via one or more of the N sinking transistors can be disabled if path(s) through the transmission gate(s) are disabled. By contrast, the sinking of current via sinking transistor **831** is not impacted by any of the N transmission gates. $I_N$, which is the sum of the currents sunk through the sinking transistors **826**, **828**, **830** and **831**, tracks $I_{ref}$.

As will be appreciated by those skilled in the art, the pull-up and pull-down transistors **806**, **807**, **824**, **825** prevent the sourcing and the sinking transistors from turning on when their corresponding transmission gates are turned off. Also, it will be understood that each of the M transmission gates in the source portion of the charge pump **800** could be replaced by, for example, a PMOS transistor that would achieve a result similar to that achieved by use of a transmission gate. Similarly, each of the N transmission gates in the sink portion of the charge pump **800** could be replaced by, for example, an NMOS transistor that would achieve a result similar to that achieved by use of a transmission gate.

Still with reference to Figure 8, it will be apparent that sourcing current $I_M$ will be largest when all three of the sourcing transistors **808**, **810** and **813** are sourcing current, and when less than all three transistors are sourcing current, $I_M$ will be smaller. Similarly, it will be seen that $I_N$ will be largest when all three of the sinking transistors **826**, **828** and **831** are sinking current, and $I_N$ will be smaller when less than all three sinking transistors are sinking current. In this manner, the illustrated charge pump **800** permits scaling of charge pump currents to be carried out.

If one takes into account that, in the illustrated charge pump **800**, the phase shift corresponding to steady state will approximately follow equation (3) below:

## (3) Phase Shift = 180* $I_N$/($I_M$+ $I_N$).

It will be seen that scaling of charge pump currents as previously described provides for the ability to make fine-tuned adjustments in phase shifting. Also, if $I_N$ and $I_M$ are expressed as $(N+1)*I_{ref}$ and $(M+1)*I_{ref}$ respectively, where N and M represent the current mirror ratios, then the relationship expressed in equation (4) below also holds:

## (4) Phase Shift = 180* (N+1)/(M+N+2).

As will be appreciated by those skilled in the art, a system that includes the charge pump **800** can also include a main controller having registers that provide the enable signals ep[M:0] and epb[M:0] for controlling which of the M transmission gates in the source portion of the charge pump **800** are enabled or disabled, and for controlling which of the M pull-up transistors in the source portion of the charge pump **800** are made conducting or non-conducting. In particular, each of the enable signals from such main controller registers would be applied to at least one of the gates of the transmission gates and/or pull-up/pull-down transistors. Similar enable signals could also be provided in a similar manner for similar control in the sink portion of the charge pump **800**.

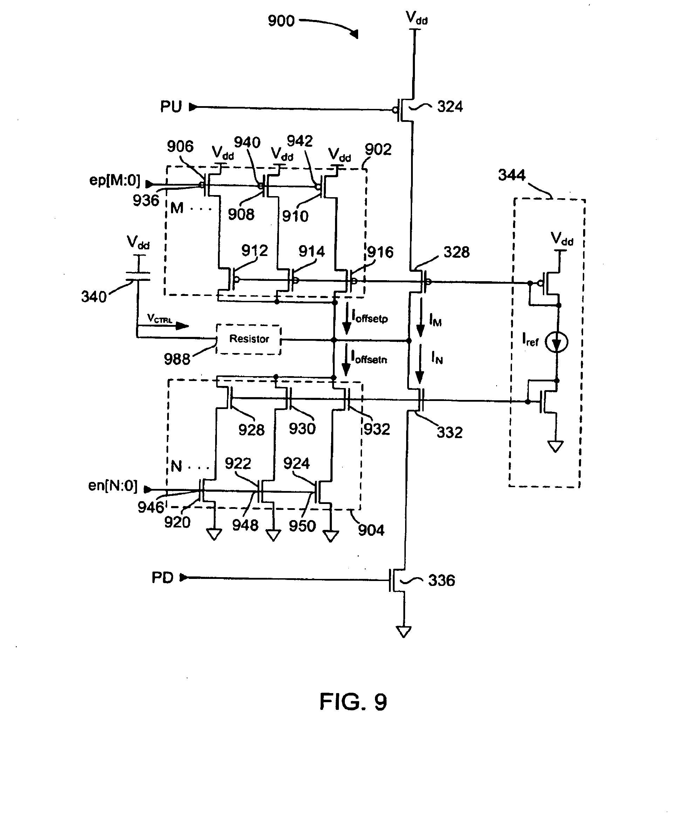

Figure 9 is a circuit schematic of a charge pump **900** in accordance with yet another example embodiment. The operations of the sourcing transistor **328,** the sinking transistor **332**, the current mirror **344** and the switching transistors **324** and **336** have been previously described, and hence it is unnecessary to repeat what has been previously described in detail. In the previously shown charge pump embodiments, the magnitude of currents $I_M$ and $I_N$ provided when PU or PD are at their active logic levels, can be adjusted by selectively turning on secondary switching transistors, secondary sourcing transistors, and select transistors. This is due to the configuration of the shown charge pump circuits in which the transistors receiving control signals PU and PD are in series with the sourcing and sinking transistors. In the presently shown embodiment of Figure 9, offset currents can be independently applied to currents $I_M$ and $I_N$. Typically, these offset currents will be continuously generated.

In at least one example, the PU and PD signals applied at the gates of the switching transistors **324** and **336** are generated by a Phase Frequency Detector (PFD) such as the PFD described in "Phase-Locked Loops: Design, Simulation, and Applications, 4th Edition", Best, Roland E., McGraw-Hill, ©1999 at pgs. 92-102.

Turning now to the source portion of the charge pump **900**, there is a supplemental source circuit that in the illustrated example embodiment comprises a first programmable array of transistors **902** for generating offset current $I_{OFFETP}$. Three of M pairs of PMOS transistors are shown within the illustrated programmable array of transistors **902**, with transistors of each pair being connected in series. In the illustrated example embodiment, the circuitry for controlling current sourcing in each pair comprises a select transistor. Each of select transistors **906, 908** and **910** have their drains coupled to $V_{dd}$ and their sources electrically connected to the drains of one of sourcing transistors **912, 914** and **916.**

The illustrated charge pump **900** also includes a supplemental sink circuit in the sink portion of the charge pump **900**. In the illustrated example embodiment, the supplemental sink circuit comprises a second programmable array of transistors **904** for generating offset current $I_{OFFSETN}$. Three of N pairs of NMOS transistors are shown within the illustrated programmable array of transistors **904**, with transistors of each pair being connected in series. In the illustrated example embodiment, the circuitry for controlling current sinking in each pair comprises a select transistor. Three select transistors **920, 922** and **924** are shown. Each of the select transistors **920, 922** and **924** has its drain coupled to ground potential and its source coupled to one of the drains of sinking transistors **928, 930** and **932**.

$I_{OFFSETP}$, a positive phase shift producing current which is the sum of the currents sourced through the sourcing transistors **912, 914** and **916**, tracks the charge pump current. In operation, $I_{OFFSETP}$ in the source portion of the charge pump **900** can be increased or decreased by turning on or turning off one or more of the select transistors **906, 908** and **910**. The select transistors **906, 908** and **910** are turned on by applying a logic low signal at their respective gates **936, 940** and **942**.

$I_{OFFSETN}$, a negative phase shift producing current which is the sum of the currents sunk through the sinking transistors **928, 930** and **932**, tracks the charge pump current. $I_{OFFSETN}$ in the sink portion of the charge pump **900** can be increased or decreased by turning on or turning off one or more of the select transistors **920, 922** and **924**. The select transistors **920, 922** and **924** are turned on when a logic high signal is applied to their respective gates **946, 948** and **950**.

It will be understood that the offset currents can be used to cause phase shifting. For instance, the phase shift in the illustrated charge pump **900** is equal to the difference between $I_{OFFSETP}$ and $I_{OFFSETN}$ multiplied by 360 and divided by $I_M$. In some examples, the sourcing transistors of the programmable array **902** have, from the $M^{th}$ to the 1st, incrementally larger device channel W/L ratios, and the sink transistors of the programmable array **904** also have, from the $N^{th}$ to the 1st, incrementally larger device channel W/L ratios. For instance, the transistors **916** and **932**, in one example, have equal device channel W/L ratios that are ½ the device channel W/L ratios of the transistors **328** and **332,** the transistors **914** and **930** have device channel W/L ratios that are ⅓ the device channel W/L ratios of the transistors **328** and **332,** and the transistors **912** and **928** have device channel W/L ratios that are % the device channel W/L ratios of the transistors **328** and **332.** With these example values, any of various different phase shifts can be realized. For instance, if the select transistors **906, 910, 922** and **924** are turned off, and the select transistors **908** and **920** are turned on, the phase shift would be (1/3-1/4)*360° = 30°. Alternatively say the select transistors **910, 922** and **924** are turned off, and the select transistors **906, 908** and **920** are turned on, the phase shift would be ((1/3+1/4)-1/4)*360° = 120°. It will be understood that although in the above example, each of the sourcing transistors has different ratios to accommodate phase shift adjustments that can either be quite fine or more coarse, in other examples the sourcing transistors could each have the same ratio.

As will be appreciated by those skilled in the art, a system that includes the charge pump **900** can also include a main controller having registers that provide the enable signals for controlling which of the select transistors **906, 908, 910, 920, 922** and **924** are made conducting or non-conducting. In particular, each of the enable signals from such main controller registers would be applied to one of the gates **936, 940, 942, 946, 948** and **950.**

If the charge pump **900** is designed into a PLL then, as will be appreciated by those skilled in the art, a resistor, such as illustrated resistor **988,** is typically added in series with the capacitor **340.** By contrast, if the charge pump **900** is designed into a DLL, then the resistor **988** would be absent.

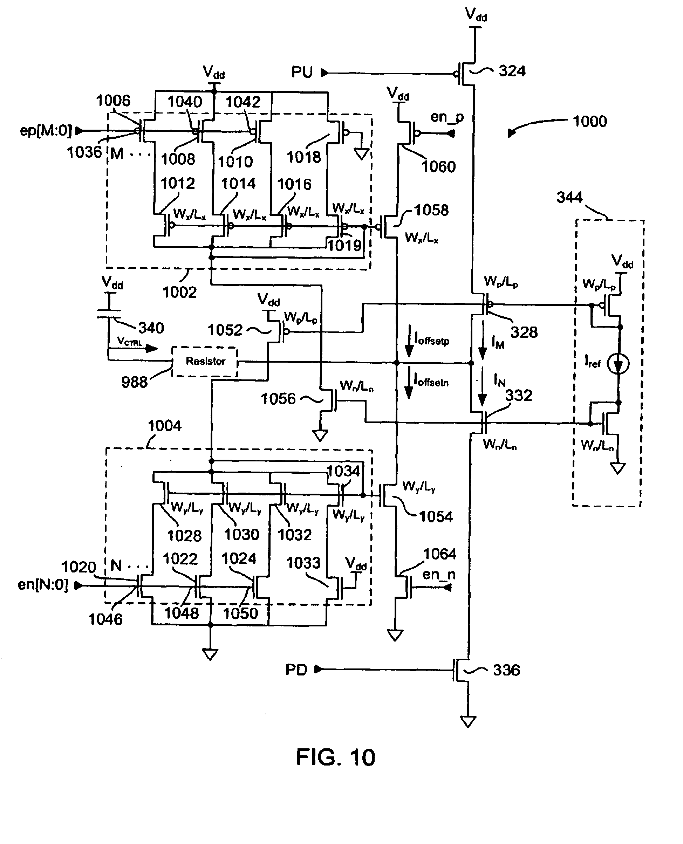

Figure 10 is a circuit schematic of a charge pump **1000** in accordance with yet another example embodiment. This circuit provides offset currents which can be independently applied to currents $I_M$ and $I_N$, and which will typically be continuously generated. The circuit embodiment of Figure 9 has first and second programmable array of transistors connected directly to sourcing transistor **328** and sinking transistor **332,** thereby directly generating the offset currents. The circuit of the present embodiment on the other hand uses its first and second programmable array of transistors to control an offset generator circuit for generating the offset currents. The operations of the sourcing transistor **328,** the sinking transistor **332,** the current mirror **344** and the switching transistors **324** and **336** have been previously described, and hence it is unnecessary to repeat what has been previously described in detail. In at least one example, the PU and PD signals applied at the gates of the switching transistors **324** and **336** are generated by a PFD of the type described in the previously referred to Roland E. Best reference.

With reference to the source portion of the charge pump **1000,** there is a supplemental source circuit that in the illustrated example embodiment comprises a programmable array of transistors **1002,** a bias transistor **1056,** a current source transistor **1058,** and transistor **1060.** The illustrated programmable array of transistors **1002** includes M+1 pairs of PMOS transistors, with transistors of each pair being connected in series. Each of select transistors **1006, 1008** and **1010** have their drains coupled to $V_{dd}$ and their sources electrically connected to the drains of one of gate-drain-connected transistors **1012, 1014** and **1016.** As before, while in some examples each of the gate-drain connected transistors will have the same ratios, in other examples, each of the gate-drain connected transistors will have a different ratio. An additional pair of PMOS transistors **1018, 1019** is provided to prevent deviation from the calibrated offset current (under certain conditions) as will be explained subsequently.

With reference to the sink portion of the charge pump **1000,** there is a supplemental sink circuit that in the illustrated example embodiment comprises a programmable array of transistors **1004,** a bias transistor **1052,** a current sink transistor **1054,** and transistor **1064.**

The illustrated programmable array of transistors **1004** includes N+1 pairs of NMOS transistors, with transistors of each pair being connected in series. Each of select transistors **1020, 1022** and **1024** has a drain coupled to ground potential and its source coupled to one of the drains of gate-drain connected transistors **1028, 1030** and **1032.** An additional pair of NMOS transistors **1033, 1034** is provided to prevent deviation from calibrated offset current (under certain conditions) as will be explained subsequently.

The array of transistors **1002** in the source portion of the illustrated charge pump **1000** is provided for setting offset current $I_{OFFSETP}$. Also, it will be understood, as explained subsequently in more detail, that the circuitry for controlling the sourcing of current through sourcing transistor **1058** comprises the array of transistors **1002.** The array of transistors **1004** in the sink portion of the illustrated charge pump **1000** is provided for setting offset current $I_{OFFSETN}$. Also, it will be understood that, as explained subsequently in more detail, the circuitry for controlling the sinking of current through sinking transistor **1054** comprises the array of transistors **1004.**

In the illustrated example, transistor **1052,** which is in a current mirror relationship with the PMOS FET of $I_{ref}$, has the same device channel W/L ratio as the FET **328** and the PMOS FET of $I_{ref}$. Also, each of the gate-drain connected transistors **1028, 1030** and **1032** has the same device channel W/L ratio as the sinking transistor **1054,** and the sinking transistor **1054** is in a current mirror relationship with the array of transistors **1004** so that the sinking of current through the sinking transistor **1054** is controlled by the array of transistors **1004.** Furthermore, with device channel W/L ratios having relative values as mentioned above, the magnitude of $I_{OFFSETN}$ is roughly equal to $\dfrac{1}{H+1} \cdot I_{ref}$ (where H

is the number of select transistors in the array of transistors **1004** that are turned on, and H being any whole number less than or equal to N, the total number of select transistors in the array of transistors **1004**). Those skilled in the art will appreciate the impact(s) of changing the relative device channel W/L ratios. For example, with all other factors remaining the same, a percentage increase/decrease in the device channel W/L ratio of the transistor **1052** will result in a correspondingly equal percentage increase/decease in the magnitude of $I_{OFFSETN}$.

In the illustrated example, transistor **1056,** which is in a current mirror relationship with the NMOS FET of $I_{ref}$, has the same device channel W/L ratio as the FET **332** and the NMOS FET of $I_{ref}$. Also, each of the gate-drain connected transistors **1012, 1014** and **1016** has the same device channel W/L ratio as the sourcing transistor **1058,** and the sourcing transistor **1058** is in a current mirror relationship with the array of transistors **1002** so that the sourcing of current through the sourcing transistor **1058** is controlled by the array of transistors **1002**. Furthermore, with relative device channel W/L ratios having relative values as mentioned above, the magnitude of $I_{OFFSETP}$ is roughly equal to $\frac{1}{G+1} * I_{ref}$ (where G is the number of select transistors in the array of transistors **1002** that are turned on, and G being any whole number less than or equal to M, the total number of select transistors in the array of transistors **1002**). Those skilled in the art will appreciate the impact(s) of changing the relative device channel W/L ratios. For example, with all other factors remaining the same, a percentage increase/decrease in the device channel W/L ratio of the transistor **1056** will result in a correspondingly equal percentage increase/decease in the magnitude of $I_{OFFSETP}$.

As previously explained in connection with Figure 9, the phase shift in the illustrated charge pump **1000** is equal to the difference between $I_{OFFSETP}$ and $I_{OFFSETN}$ multiplied by 360 and divided by $I_M$. Substituting for the previously defined variables G and H, it will be seen that the phase shift can be expressed as follows:

$$360 * \left( \frac{1}{G+1} - \frac{1}{H+1} \right).$$ Thus, in operation, $I_{OFFSETP}$ in the source portion of the charge pump **1000** can be increased or decreased by turning on or turning off one or more of the select transistors **1006, 1008** and **1010**. The select transistors **1006, 1008** and **1010** are turned on by applying a logic low signal at their respective gates **1036, 1040** and **1042** via control signals ep[M:0]. Similarly, $I_{OFFSETN}$ in the sink portion of the charge pump **1000** can be increased or decreased by turning on or turning off one or more of the select transistors **1020, 1022** and **1024**. The select transistors **1020, 1022** and **1024** are turned on when a logic high signal is applied to their respective gates **1046, 1048** and **1050** via control signals en[N:0].

As will be appreciated by those skilled in the art, a system that includes the charge pump **1000** can also include a main controller having registers that provide the enable signals for controlling which of the select transistors **1006, 1008, 1010, 1020, 1022** and **1024** are made conducting or non-conducting. In particular, each of the enable signals from such main controller registers would be applied to one of the gates **1036, 1040, 1042, 1046, 1048** and **1050**.

The offset generator includes transistors **1060, 1064, 1058** and **1054,** where additional enable signals en_p and en_n are applied to transistors **1060** and **1064** respectively. Under conditions where no select transistors in the array of transistors **1002** are turned on, en_p will be set to an inactive logic level (which is logic high in the illustrated example) and the transistors **1018, 1019** and **1060** will help ensure deviation from calibrated offset current is avoided. For example, the voltage at the node to which the drain of the bias transistor **1056** is connected will not be allowed to float. Similarly under conditions where no select transistors in the array of transistors **1004** are turned on, en_n will be set to an inactive logic level (which is logic low in the illustrated example) and the transistors **1033, 1034** and **1064** will help ensure deviation from calibrated offset current is avoided. For example, the voltage at the node to which the drain of the bias transistor **1052** is connected will not be allowed to float.

It will be understood that in those instances where M and N are greater than 1, few transistors are directly connected to the $V_{CTRL}$ node of the charge pump **1000** as compared to the $V_{CTRL}$ node of the charge pump **900**. As a result, the $V_{CTRL}$ node of charge pump **1000** has less capacitance loading as compared to the charge pump **900**. Also, if the charge pump **1000** is designed into a PLL then, as will be appreciated by those skilled in the art, a resistor, such as the illustrated resistor **988,** is typically added in series with the capacitor **340.** By contrast, if the charge pump **1000** is designed into a DLL, then the resistor **988** would be absent.

A number of circuits and methods for scaling of charge pump currents in order to make fine-tuned adjustments in phase shifting have been described and illustrated. It will be apparent that these circuits and methods can be modified by one skilled in the art, and in so doing other circuits and methods can be realized which share at least some non-trivial similarities to the charge pump current scaling circuits and methods described herein. For example, one could incorporate circuitry into a charge pump that would continually cause an offset current to be sourced/added into and/or sunk/removed from the capacitor **340** regardless of the logic levels of the PU and PD control signals. Such an implementation would, in some examples, be less energy efficient than implementations previously described in this disclosure. It should be noted that capacitor **340** shown in the embodiments of the invention shown in Figures 7 and 8 can be a passive component of the loop filter, or alternately, capacitor **340** can be a component of charge pumps **700** and **800**.

It will be understood that adjustments in phase shifting in accordance with example embodiments could be carried out, for example, during testing/calibration and/or dynamically.

Certain adaptations and modifications of the described embodiments can be made. Therefore, the above discussed embodiments are considered to be illustrative and not restrictive.

**Claims**

1. A method for providing charge up (PU) and charge down (PD) signals having active and inactive logic levels to a charge pump (105), the charge pump (105) charging a capacitance (340) in response to the active logic level of the charge up signal (PU), and discharging the capacitance in response to the active logic level of the charge down signal (PD), the method comprising:

in response to detection of a first edge of a reference clock signal (CLK_REF), changing (602) the inactive logic level of the charge down signal (PD) to the active logic level;
**characterized in that**:

the charge pump (105) is in a delay-looked loop comprising a voltage control delay line (102), and the method further comprising:

in response to detection of an edge of a feedback clock signal (CLK_FB), provided by the voltage control delay line, within less than 180 degrees from said first edge, changing (606) the inactive logic level of the charge up signal (PU) to the active logic level, and changing (608) the active logic level of the charge down signal (PD) to the inactive logic level; and
in response to detection that an edge of an additional reference signal (CLK_180) at a point in time about midway between said first edge and a subsequent edge of said reference clock signal (CLK_REF) has passed, changing the active logic level of the charge up signal (PU) to the inactive logic level, while maintaining the charge down signal (PD) at the inactive logic level.

2. The method as claimed in claim 1, wherein both charging and discharging are disabled during a period of time between said point in time and said subsequent edge.

3. The method as claimed in claim 1, wherein the active logic level of the charge up signal (PU) is logic low, said inactive logic level of the charge up signal (PU) is logic high, the active logic level of the charge down signal (PD) is logic high and said inactive logic level of the charge down signal (PD) is logic low.

4. The method as claimed in claim 1, wherein said first edge, said subsequent edge, and said edge of the feedback clock signal (CLK_FB) are rising edges.

5. The method as claimed in claim 1, wherein charging occurs during about a quarter of one period of said reference clock signal (CLK_REF) and discharging occurs during about another quarter of said one period, if the charge pump (105) is in a steady state.

6. The method as claimed in claim 1, wherein said reference clock signal (CLK_REF) is a 50 percent duty cycle clock, and said point in time corresponds to an opposite edge of said reference clock signal (CLK_REF), said opposite edge next in succession to said first edge.

7. The method as claimed in claim 1, wherein the additional reference signal (CLK_180) includes a timing signal that is 180 degrees phase shifted relative to said reference clock signal (CLK_REF), and said point in time corresponds to an edge of the timing signal..

8. A delay-locked loop comprising:

a voltage control delay line (102) for receiving a reference clock signal (CLK_REF) and for delaying said reference clock signal (CLK_REF) to provide a feedback clock signal (CLK_FB);
a phase detector (104) for receiving said reference clock signal (CLK REF), an additional reference signal, and said feedback clock signal (CLK_FB), said phase detector (104) generating a charge down (PD) signal having a first duration of time in response to a first edge of said reference clock signal (CLK_REF), a charge up signal (PU) having a second duration of time in response to an edge of the feedback clock signal (CLK_FB) occurring within less than 180 degrees from said first edge, the first duration of time being substantially similar to a first time between the first edge of the reference clock signal (CLK_REF) and the edge of the feedback clock signal (CLK_FB), the second duration of time being substantially similar to a second time between the edge of the feedback clock signal (CLK_FB) and a midway signal edge occurring between the first edge and a subsequent edge of the reference clock signal (CLK_REF);
a loop filter (106) including a capacitor (340), for providing a variable bias voltage for selecting a delay to be added to said reference clock signal (CLK_REF) by said voltage control delay line; and
a charge pump (105) including at least two switching transistors (324, 336), one of the switching transistors (324) permitting current to be added into said capacitor (340) when switched on in response to said charge up signal (PU), another of said switching transistors (336) permitting current to be removed from said capacitor (340) when switched on in response to said charge down signal (PD).

9. The delay-locked loop as claimed in claim 8, wherein during one period of said reference clock signal (CLK_REF) the charge pump is disabled during about half of said period.

**10.** The delay-locked loop as claimed in claim 8, wherein the one of the switching transistors is a PMOS transistor (324), and the another of the switching transistors is an NMOS transistor (336).

**11.** The delay-locked loop as claimed in claim 10, wherein the gates of said PMOS transistor (324) and said NMOS transistor (336) are adapted to receive said charge up (PU) and charge down (PD) signals respectively, said PMOS transistor (324) being switched on when said charge up signal (PU) is logic low and said NMOS transistor (336) being switched on when said charge down signal (PD) is logic high.

**12.** The delay-locked loop as claimed in claim 11, wherein said charge up signal (PU) transitions from logic high to logic low in response to a rising edge of said feedback clock signal (CLK_FB), and said charge down signal (PD) transitions from logic low to logic high in response to a rising edge of said reference clock signal (CLK_REF).

**13.** The delay-locked loop as claimed in claim 8, wherein if said charge pump (105) is in a steady state, during a period of said reference clock signal (CLK_REF) said capacitor (340) is charged during about a quarter of said period, and discharged during about a quarter of said period.

**14.** The delay-locked loop as claimed in claim 8, wherein said phase detector (104) comprises at least four D Flip-Flops (504, 506, 510, 512), and each of said clock signals is received by at least one of said four D Flip-Flops (504, 506, 510, 512) at a clock input.

**Patentansprüche**

**1.** Verfahren zum Bereitstellen von Lade-(Charge Up; PU) und Entlade-(Charge Down; PD)-Signalen aufweisend aktive und inaktive logische Pegel an eine Ladepumpe (105), wobei die Ladepumpe (105) eine Kapazität (340) in Reaktion auf den aktiven logischen Pegel des Ladesignals (PU) lädt, und die Kapazität in Reaktion auf den aktiven logischen Pegel des Entladesignals (PD) entlädt, wobei das Verfahren umfasst:

in Reaktion auf ein Erkennen einer ersten Flanke eines Referenztaktsignals (CLK_REF), Ändern (602) des inaktiven logischen Pegels des Entladesignals (PD) zu dem aktiven logischen Pegel;
**dadurch gekennzeichnet, dass**:

die Ladepumpe (105) sich in einer Delay-Locked-Loop befindet, aufweisend eine Spannungssteuerungsverzögerungsleitung (102), und das Verfahren weiterhin umfasst:

in Reaktion auf ein Erkennen einer Flanke eines Feedback-Taktsignals (CLK_FB), welches von der Spannungssteuerungsverzögerungsleitung bereitgestellt wird, innerhalb von weniger als 180 Grad von der ersten Flanke, Ändern (606) des inaktiven logischen Pegels des Ladesignals (PU) zu dem aktiven logischen Pegel, und Ändern (608) des aktiven logischen Pegels des Entladesignals (PD) zu dem inaktiven logischen Pegel; und
in Reaktion auf ein Erkennen, dass eine Flanke eines zusätzlichen Referenzsignals (CLK_180) zu einem Zeitpunkt etwa mittig zwischen der ersten Flanke und einer darauffolgenden Flanke des Referenztaktsignals (CLK_REF), Ändern des aktiven logischen Pegels des Ladesignals (PU) zu dem inaktiven logischen Pegel, während das Entladesignal (PD) auf dem inaktiven logischen Pegel gehalten wird.

**2.** Verfahren nach Anspruch 1, wobei sowohl ein Laden wie auch ein Entladen während einer Zeitdauer zwischen dem Zeitpunkt und der darauffolgenden Flanke deaktiviert werden.

**3.** Verfahren nach Anspruch 1, wobei der aktive logische Pegel des Ladesignals (PU) ein logischer LOW-Pegel ist, der inaktive logische Pegel des Ladesignals (PU) ein logischer HIGH-Pegel ist, der aktive logische Pegel des Entladesignals (PD) ein logischer HIGH-Pegel ist und der inaktive logische Pegel des Entladesignals (PD) ein logischer LOW-Pegel ist.

**4.** Verfahren nach Anspruch 1, wobei die erste Flanke, die darauffolgende Flanke und die Flanke des Feedback-Taktsignals (CLK_FB) ansteigende Flanken sind.

**5.** Verfahren nach Anspruch 1, wobei ein Laden während etwa eines Viertels einer Periode des Referenztaktsignals (CLK_REF) stattfindet und ein Entladen während etwa eines anderen Viertels der einen Periode stattfindet, falls die Ladepumpe (105) sich in stabilem Zustand befindet.

**6.** Verfahren nach Anspruch 1, wobei das Referenztaktsignal (CLK_REF) einen Duty-Cycle von 50% aufweist und der Zeitpunkt mit einer entgegengesetzten Flanke des Referenztaktsignals (CLK_REF) korrespondiert, wobei die entgegengesetzte Flanke die auf die erste Flanke nächstfolgende Flanke ist.

7. Verfahren nach Anspruch 1, wobei das zusätzliche Referenzsignal (CLK-180) ein Timing-Signal beinhaltet, das gegenüber dem Referenztaktsignal (CLK_REF) 180 Grad phasenverschoben ist und der Zeitpunkt mit einer Flanke des Timing-Signals korrespondiert.

8. Delay-Locked Loop aufweisend:

   eine Spannungssteuerungsverzögerungsleitung (102) zum Empfangen eines Referenztaktsignal (CLK_REF) und zum Verzögern des Referenztaktsignals (CLK_REF), um ein Feedback-Taktsignal (CLK_FB) bereitzustellen; einen Phasendetektor (104) zum Empfangen des Referenztaktsignals (CLK_REF), eines zusätzlichen Referenzsignals und des Feedback-Taktsignals (CLK_FB), wobei der Phasendetektor (104) ein Ladesignal (PD) erzeugt, aufweisend eine erste Zeitdauer in Reaktion auf eine erste Flanke des Referenztaktsignals (CLK_REF), ein Entladesignal (PU) aufweisend eine zweite Zeitdauer in Reaktion auf eine Flanke des Feedback-Taktsignals (CLK_FB), das innerhalb von weniger als 180 Grad von der ersten Flanke auftritt, wobei die erste Zeitdauer im Wesentlichen ähnlich mit einer ersten Zeitspanne zwischen der ersten Flanke des Referenztaktsignals (CLK_REF) und der ersten Flanke des Feedback-Taktsignals (CLK_FB) ist, wobei die zweite Zeitdauer im Wesentlichen ähnlich mit einer zweiten Zeitspanne zwischen der Flanke des Feedback-Taktsignals (CLK_FB) und einer mittleren Signalflanke ist, die zwischen der ersten Flanke und einer darauffolgenden Flanke des Referenztaktsignals (CLK_REF) auftritt; einen Loop-Filter (106), beinhaltend einen Kondensator (340), um eine variable Vorspannung zur Auswahl einer Verzögerung, die dem Referenztaktsignal (CLK_REF) durch die Spannungssteuerungsverzögerungsleitung hinzugefügt werden soll, bereitzustellen; und eine Ladepumpe (105), beinhaltend zumindest zwei Schalttransistoren (324, 336), wobei einer der Schalttransistoren (324) ermöglicht, dass dem Kondensator (340) Strom hinzugefügt wird, wenn er in Reaktion auf das Ladesignal (PU) eingeschaltet wird, und ein anderer der Schalttransistoren (336) ermöglicht, dass Strom von dem Kondensator (340) entnommen wird, wenn er in Reaktion auf das Entladesignal (PD) eingeschaltet wird.

9. Delay-Locked Loop nach Anspruch 8, wobei während einer Zeitdauer des Referenztaktsignals (CLK_REF) die Ladepumpe während etwa der Hälfte der Zeitdauer deaktiviert ist.

10. Delay-Locked Loop nach Anspruch 8, wobei der eine der Schalttransistoren ein PMOS-Transistor (324) und der andere der Schalttransistoren ein NMOS-Transistor (336) ist.

11. Delay-Locked Loop nach Anspruch 10, wobei die Gates des PMOS-Transistors (324) und des NMOS-Transistors (336) geeignet sind, die Lade-(PU)- bzw. End-lade-(PD)-Signale zu empfangen, und der PMOS-Transistor (324) eingeschaltet wird, wenn das Ladesignal (PU) sich auf einem logischen LOW-Pegel befindet und der NMOS-Transistor (336) eingeschaltet wird, wenn sich das Entladesignal (PD) auf einem logischen HIGH-Pegel befindet.

12. Delay-Locked Loop nach Anspruch 11, wobei das Ladesignal (PU) von einem logischen HIGH-Pegel zu einem logischen LOW-Pegel übergeht, in Reaktion auf eine ansteigende Flanke des Feedback-Taktsignals (CLK_FB) und das Entladesignal (PD) von einem logischen LOW-Pegel zu einem logischen HIGH-Pegel übergeht, in Reaktion auf eine ansteigende Flanke des Referenztaktsignals (CLK_REF).

13. Delay-Locked Loop nach Anspruch 8, wobei während einer Periode des Referenztaktsignals (CLK_REF) der Kondensator (340) während etwa eines Viertels der Periode geladen wird und während etwa eines Viertels der Periode entladen wird, falls sich die Ladepumpe (105) in einem stabilen Zustand befindet.

14. Delay-Locked Loop nach Anspruch 8, wobei der Phasendetektor (104) zumindest vier D-Flip-Flops (504, 506, 510, 512) aufweist und jedes der Taktsignale von zumindest einem der vier D-Flip-Flops (504, 506, 510, 512) an einem Takteingang empfangen wird.

**Revendications**

1. Un procédé pour délivrer des signaux de montée de charge (PU) et de baisse de charge (PD) présentant des niveaux logiques actif et inactif à une pompe de charge (105), la pompe de charge (105) chargeant un condensateur (340) en réponse au niveau logique actif du signal de montée de charge (PU), et déchargeant le condensateur en réponse au niveau logique actif du signal de baisse de charge (PD), le procédé comprenant:

   en réponse à la détection d'un premier front d'un signal d'horloge de référence (CLK_REF), le changement (602) du niveau logique inactif du signal de baisse de charge (PD) vers le niveau logique actif,

**caractérisé en ce que** :

la pompe de charge (105) est une boucle à verrouillage de retard comprenant une ligne à retard à contrôle en tension (102), et le procédé comprenant en outre :

en réponse à la détection d'un front d'un signal d'horloge de rétroaction (CLK_FB), délivré par la ligne à retard à contrôle en tension, situé à moins de 180 degrés à partir dudit premier front, le changement (606) du niveau logique inactif du signal de montée de charge (PU) vers le niveau logique actif, et le changement (608) du niveau logique actif du signal de baisse de charge (PD) vers le niveau logique inactif; et

en réponse à la détection qu'il est passé un front d'un signal de référence additionnel (CLK_180) en un instant situé approximativement à mi-chemin entre ledit premier front et un front suivant dudit signal d'horloge de référence (CLK_REF), le changement du niveau logique actif du signal de montée de charge (PU) vers le niveau logique inactif, tout en maintenant le signal de baisse de charge (PD) au niveau logique inactif.

2. Le procédé de la revendication 1, dans lequel la charge et la décharge sont toutes deux désactivées pendant une période temporelle comprise entre ledit instant et ledit front suivant.

3. Le procédé de la revendication 1, dans lequel le niveau logique actif du signal de baisse de charge (PU) est un bas logique, ledit niveau logique inactif du signal de montée de charge (PU) est un haut logique, le niveau logique actif du signal de baisse de charge (PD) est un haut logique et ledit niveau logique inactif du signal de baisse de charge (PD) est un bas logique.

4. Le procédé de la revendication 1, dans lequel ledit premier front, ledit front suivant et ledit front du signal d'horloge de rétroaction (CLK_FB) sont des fronts montants.

5. Le procédé de la revendication 1, dans lequel la charge a lieu pendant approximativement un quart d'une période dudit signal d'horloge de référence (CLK_REF) et la décharge a lieu pendant approximativement un autre quart de ladite période, si la pompe de charge (105) est dans un état stationnaire.

6. Le procédé de la revendication 1, dans lequel ledit signal d'horloge de référence (CLK_REF) est une horloge avec un rapport cyclique de 50 pour cent, et ledit instant correspond à un front opposé dudit signal d'horloge de référence (CLK_REF), ledit front opposé étant le suivant en succession dudit premier front.

7. Le procédé de la revendication 1, dans lequel le signal de référence additionnel (CLK-180) comprend un signal de séquencement qui est déphasé de 180 degrés par rapport audit signal d'horloge de référence (CLK_REF), et ledit instant correspond à un front du signal de séquencement.

8. Une boucle à verrouillage de retard, comprenant :

une ligne à retard à contrôle en tension (102) pour recevoir un signal d'horloge de référence (CLK_REF) et pour retarder ledit signal d'horloge de référence (CLK_REF) pour produire un signal d'horloge de rétroaction (CLK_FB) ;
un détecteur de phase (104) pour recevoir ledit signal d'horloge de référence (CLK_REF), un signal de référence additionnel, et ledit signal d'horloge de rétroaction (CLK_FB), ledit détecteur de phase (104) générant un signal de baisse de charge (PD) présentant une première durée en réponse à un premier front dudit signal d'horloge de référence (CLK_REF), un signal de montée de charge (PU) présentant une seconde durée en réponse à un front du signal d'horloge de rétroaction (CLK_FB) se présentant à moins de 180 degrés par rapport audit premier front, la première durée étant substantiellement semblable à un premier temps entre le premier front du signal d'horloge de référence (CLK_REF) et le front du signal d'horloge de rétroaction (CLK_FB), la seconde durée étant substantiellement semblable à un second temps entre le front du signal d'horloge de rétroaction (CLK_FB) et un front de signal à mi-chemin se présentant entre le premier front et un front suivant du signal d'horloge de référence (CLK_REF) ;
un filtre de boucle (106) comprenant un condensateur (340), pour produire une tension de polarisation variable pour sélectionner un retard à ajouter audit signal d'horloge de référence (CLK_REF) par ladite ligne à retard à contrôle en tension ; et
une pompe de charge (105) comprenant au moins deux transistors de commutation (324, 336), l'un des transistors de commutation (324) permettant d'ajouter du courant dans ledit condensateur (340) lorsqu'il est commuté passant en réponse audit signal de montée de charge (PU), un autre desdits transistors de commutation (336) permettant d'extraire du courant dudit condensateur (340) lorsqu'il est commuté passant en réponse audit signal de baisse de charge (PD).

9. La boucle à verrouillage de retard de la revendication 8, dans laquelle durant une période dudit signal d'horloge de référence (CLK_REF), la pompe de charge (105) est désactivée pendant approximativement la moitié de ladite période.

10. La boucle à verrouillage de retard de la revendication 8, dans laquelle l'un des transistors de commutation est un transistor PMOS (324), et l'autre des transistors de commutation est un transistor NMOS (336).

11. La boucle à verrouillage de retard de la revendication 10, dans laquelle les grilles dudit transistor PMOS (324) et dudit transistor NMOS (336) sont aptes à recevoir respectivement ledit signal de montée de charge (PU) et ledit signal de baisse de charge (PD), ledit transistor PMOS (324) étant commuté passant lorsque ledit signal de montée de charge (PU) est un bas logique et ledit transistor NMOS (336) étant commuté passant lorsque ledit signal de baisse de charge (PD) est un haut logique.

12. La boucle à verrouillage de retard de la revendication 11, dans laquelle ledit signal de montée de charge (PU) présente une transition d'un haut logique à un bas logique en réponse à un front montant dudit signal d'horloge de rétroaction (CLK_FB), et ledit signal de baisse de charge (PD) présente une transition du bas logique vers le haut logique en réponse à un front montant dudit signal d'horloge de référence (CLK_REF).

13. La boucle à verrouillage de retard de la revendication 8, dans laquelle si ladite pompe de charge (105) est dans un état stationnaire, pendant une période dudit signal d'horloge de référence (CLK_REF) ledit condensateur (340) est chargé pendant approximativement un quart de ladite période, et déchargé durant approximativement un quart de ladite période.

14. La boucle à verrouillage de retard de la revendication 8, dans laquelle ledit détecteur de phase (104) comprend au moins quatre flip-flops D (504, 506, 510, 512), et chacun desdits signaux d'horloge est reçu par au moins l'une des quatre flip-flops D (504, 506, 510, 512) sur une entrée d'horloge.

FIG. 1 (Prior Art)

EP 2 119 012 B1

FIG. 2 (Prior Art)

## FIG. 3

FIG. 4

EP 2 119 012 B1

**FIG. 5**

EP 2 119 012 B1

FIG. 6

**FIG. 7**

FIG. 8

FIG. 9

FIG. 10

**EP 2 119 012 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7092689 B, Boecker
- US 6483389 B1
- US 20050162200 A, Haerle

### Non-patent literature cited in the description

- Phase-Locked Loops: Design, Simulation, and Applications. McGraw-Hill, 1999, 92-102